# EUROPÄISCHE PATENTSCHRIFT

(11) **EP 0 491 656 B1**
(45) Veröffentlichungstag und Bekanntmachung des Hinweises auf die Patenterteilung: **20.09.1995**
(21) Anmeldenummer: 91810897.8
(22) Anmeldetag: 19.11.1991
(51) Int. Cl.: C30B 11/00, B22D 27/04

(54) **Giessverfahren zur Herstellung von gerichtet erstarrten oder einkristallinen Bauteilen**
Casting process for producing directionally solidified or monocrystalling components
Procédé pour la fabrication par coulage de pièces monocristallines ou de pièces à solidification directionnelle

(30) Priorität: 17.12.1990 CH 3993/90
(43) Veröffentlichungstag der Anmeldung: 24.06.1992
(73) Patentinhaber: SULZER INNOTEC AG, CH-8401 Winterthur (CH)
(72) Erfinder: Staub, Fritz, CH-8472 Seuzach (CH); Stahl, Daniel, CH-8475 Ossingen (CH)
(74) Vertreter: Heubeck, Bernhard

(56) Entgegenhaltungen:
- EP-A- 0 289 393
- EP-A- 0 477 136
- WO-A-87/04376
- GB-A- 2 056 342
- GB-A- 2 195 277
- US-A- 3 845 808
- US-A- 4 969 501
- PATENT ABSTRACTS OF JAPAN vol. 9, no. 168 (M-396)(1891)13. Juli 1985& JP-A-60 040 664 ( KOGYO GIJUTSUIN (JAPAN) ) 4. März 1985

## Beschreibung

Die Erfindung betrifft ein Giessverfahren zur Herstellung von gerichtet erstarrten oder einkristallinen Bauteilen gemäss Oberbegriff von Anspruch 1.

Zum Herstellen von gegossenen Bauteilen, die - wie beispielsweise Turbinenschaufeln von Flugzeugtriebwerken - bei hohen Temperaturen mechanisch stark beansprucht werden, eignen sich verschiedene bekannte Nickelbasislegierungen, für die beim Giessen eine gerichtete Erstarrung möglich ist. Beim gerichteten Erstarren bilden sich stengelförmige Kristalle aus; mittels einer besonderen Startphase der Erstarrung (beispielsweise mittels eines "Selektors") wird es auch möglich, das gegossene Bauteil in Form eines Einkristalls wachsen zu lassen.

Es sind verschiedene Verfahren zur Herstellung von Gussstücken durch gerichtete oder einkristalline Erstarrung bekannt. Gemeinsam ist diesen Verfahren, dass eine Gussform aus keramischem Material verwendet wird, die oben und unten offen ist: oben zum Eingiessen der Schmelze, unten zum Aufsetzen auf ein Kühlorgan, mit dem die Schmelze in direkten Kontakt kommt.

Müssen relativ grosse Bauteile hergestellt werden, so ist man gezwungen, eine spezielle Vakuumgiessanlage zu verwenden, bei der mit einer Heizeinrichtung als Wärmequelle und mit dem Kühlorgan als Wärmesenke ein "unidirektionaler" Wärmestrom erzeugt und aufrechterhalten wird (siehe beispielsweise US-PS-3.845.808). Die Heizeinrichtung wird "Suszeptor" genannt. Mittels einer Absenkvorrichtung für das Kühlorgan (inklusive Gussform) kann die Erstarrungsfront von unten nach oben durch das Bauteil geführt werden. Die Relativbewegung zwischen Gussform und Suszeptor kann auch durch Verschieben des Suszeptors erreicht werden. Mit diesem "Suszeptorverfahren" lassen sich der Temperaturgradient G im Bereich der Erstarrungsfront und die Geschwindigkeit v, mit der die dendritischen Kristalle wachsen, gut steuern.

Bei einem anderen Verfahren (CH-PS-641.985) werden die Wärmequellen nicht mehr durch Heizelemente erzeugt, sondern mittels überhitzter Schmelze und mittels besonderer Formgebung der Gussform durch Hinzunahme zusätzlicher Hohlräume: Die mit überhitzter Schmelze gefüllten Hohlräume haben die Funktion von Wärmereservoiren. Bei diesem "Verfahren mit in der Formschale integrierten Wärmereservoiren" wird die Gussform mit einem wärmedämmenden Mantel versehen; und vor dem Einschleusen in die Giesskammer wird diese Gussform zunächst in mindestens einem separaten Ofen aufgeheizt. Dieses Verfahren ist durchführbar, wenn die Bauteile nicht zu gross sind, nämlich nicht mehr als rund 15 cm in ihrer Längserstreckung.

Die Qualität der gerichtet erstarrten Gussstücke hängt davon ab, wie stark die Wachstumsrichtung der dendritischen Kristalle von einer ausgezeichneten Achse abweicht. Bei einer Turbinenschaufel zu einem Flugzeugtriebwerk verläuft diese Achse - bezüglich der Turbine - in radialer Richtung; die Dendriten sollten möglichst gut in dieser Richtung orientiert sein. Die Ausrichtung und Struktur der Dendriten hängt vom Temperaturgradienten G ab: Je kleiner dieser Gradient G ist, desto grösser ist der Abstand zwischen der Erstarrungsfront (Solidusfläche) und der Front der Dendritenspitzen (Liquidusfläche). Je grösser dieser Abstand zwischen Liquidus- und Solidusfläche ist, desto grösser wird der Abstand zwischen benachbarten Dendriten und - wie die Erfahrung zeigt - desto weniger lässt sich die Ausrichtung der Dendriten kontrollieren. Es ist daher wichtig, für grosse Temperaturgradienten G zu sorgen.

Beim "Verfahren mit in der Formschale integrierten Wärmereservoiren" nimmt der Temperaturgradient G bei der nach oben wachsenden Erstarrungsfront immer weiter ab. Dies ist der Grund dafür, dass bei diesem Verfahren für die Gussteile nur eine beschränkte Grösse möglich ist, während diese Beschränkung beim "Suszeptorverfahren" nicht vorliegt. Allerdings sind beim Suszeptorverfahren - im Gegensatz zum andern Verfahren - im Sockelbereich über dem Kühlorgan weit geringere Gradienten G möglich. Damit kann sich beim Suszeptorverfahren eine weniger gute Qualität ergeben. Eine während der Startphase sich ergebende mindere Qualität hat auch einen negativen Einfluss auf die Qualität der Bereiche, die nachfolgend erstarren.

Es ist Aufgabe der Erfindung, ein Giessverfahren zu entwickeln, bei dem die Grösse der herzustellenden Bauteile wie beim Suszeptorverfahren nicht beschränkt ist, bei dem aber eine Qualität der Bauteile möglich wird, wie sie vom Verfahren mit in der Formschale integrierten Wärmereservoiren her bekannt ist. Diese Aufgabe wird durch die Merkmale des kennzeichnenden Teils von Anspruch 1 gelöst.

Bei diesem erfindungsgemässen Verfahren verläuft die Erstarrung im Sockelbereich wie beim bekannten Verfahren mit in der Formschale integrierten Wärmereservoiren. Allerdings werden dabei die zusätzlichen Wärmereservoire nicht benötigt; der obere Teil des Gussstücks spielt dabei die Rolle des Wärmereservoirs. Die Fortsetzung der Erstarrung erfolgt nach dem bekannten Suszeptorverfahren. Die gute Qualität des Sockelbereichs hat auch eine gegenüber dem bekannten Verfahren verbesserte Qualität im oberen Teil des Gussstücks zur Folge.

Nachfolgend wird die Erfindung anhand eines Ausführungsbeispiels im Zusammenhang mit der Zeichnung näher erläutert. Es zeigen:
- Fig.1: den Aufbau einer Gussform für das bekannte Verfahren mit in der Formschale integrierten Wärmereservoiren,
- Fig.2: den Sockelbereich einer Gussform für das Suszeptorverfahren,
- Fig.3: den Sockelbereich einer Gussform für das erfindungsgemässe Verfahren,
- Fig.4a: Teil einer Anlage zur Durchführung des erfindungsgemässen Verfahrens und
- Fig.4b: ein Detail zur Anlage.

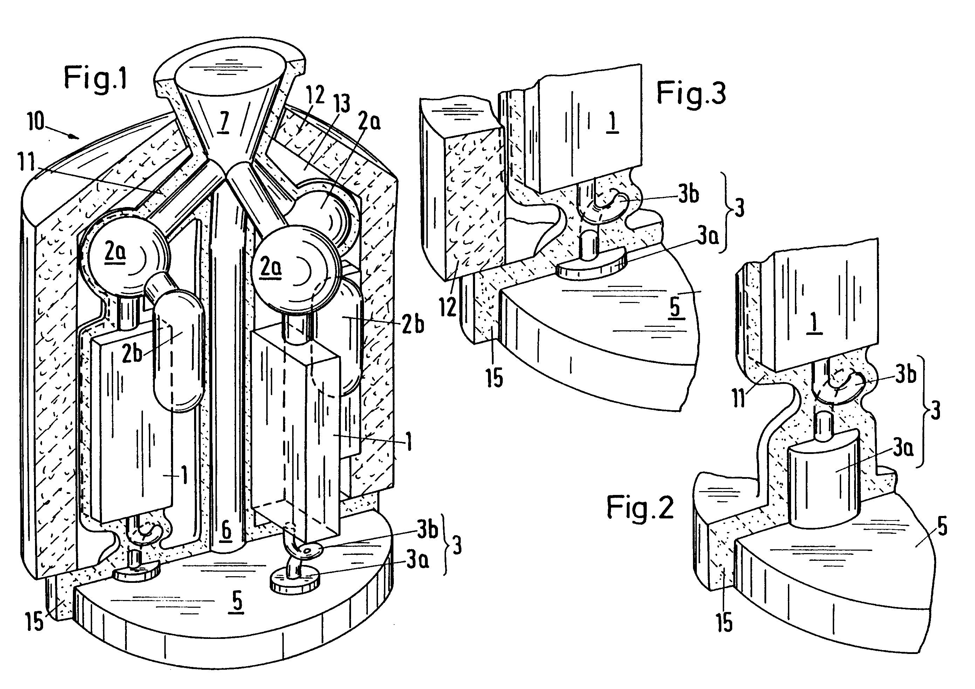

Die Gussform in Fig.1 dient zur Herstellung von einkristallin erstarrten Bauteilen. Die perspektivische Darstellung zeigt die eine Hälfte der Gussform 10 mit Formschale 11 und isolierender Hülle 12. Von der andern Hälfte sind die Hohlräume der Formschale in Form des Wachsmodells dargestellt, das zur Herstellung der Formschale dient. Es sind folgende Hohlräume, in körperlicher Darstellung, zu sehen: die Teilgiessform 1 für ein einzelnes Bauteil, das stark vereinfacht als Quader dargestellt ist; Hohlräume 2a und 2b für die durch überhitzte Schmelze gebildeten Wärmereservoire; der Starter 3 mit der scheibenförmigen Basiszone 3a und dem helixförmigen Selektor 3b; der Hohlraum 5, der beim Giessen von dem Kühlorgan eingenommen wird; das Volumen 6 des Mittelstamms, das nach dem Ausschmelzen des Wachses mit keramischem Material verschlossen wird; und schliesslich der Giesstrichter 7.

Die Formschale 11 weist am Umfang des Hohlraums 5 einen Ring 15 auf, der auf der Innenseite durch entsprechende Formgebung des Wachsmodells mit nicht dargestellten Nuten versehen wird, mittels derer die Gussform 10 bajonettverschlussartig auf dem Kühlorgan befestigt werden kann. Die isolierende Hülle 12 lässt sich aus Keramikfasermatten zusammensetzen. Der Zwischenraum 13 zwischen Formschale 11 und Hülle 12 wird vorzugsweise mit wärmedämmendem Material, beispielsweise einer Keramikwatte, gefüllt.

Beim Suszeptorverfahren ist die Formschale nicht isoliert und Hohlräume für Wärmereservoire sind keine vorhanden. Aufgeheizt wird die Gussform in der evakuierten Giesskammer, wobei sie während des Aufheizens schon auf dem Kühlorgan montiert ist. Dieser Umstand macht es erforderlich, dass die Basiszone 3a des Starters 3 - siehe Fig.2 - als Zylinder gestaltet wird, dessen Höhe einige Zentimeter beträgt. In diesem Zylinder findet eine gerichtete Erstarrung statt, deren Qualität - wie schon erwähnt - unbefriedigend sein kann.

Fig.3 zeigt als Ausschnitt den Sockelbereich einer Gussform für das erfindungsgemässe Verfahren. Hier kann die Basiszone 3a des Starters 3 weiterhin scheibenförmig sein wie bei der Gussform in Fig.1. Hingegen wird hier die Wärmedämmung 12 auf eine kranzförmige Isolation des Sockelbereichs beschränkt. Wie schon erwähnt fehlen auch hier die Hohlräume für Wärmereservoire.

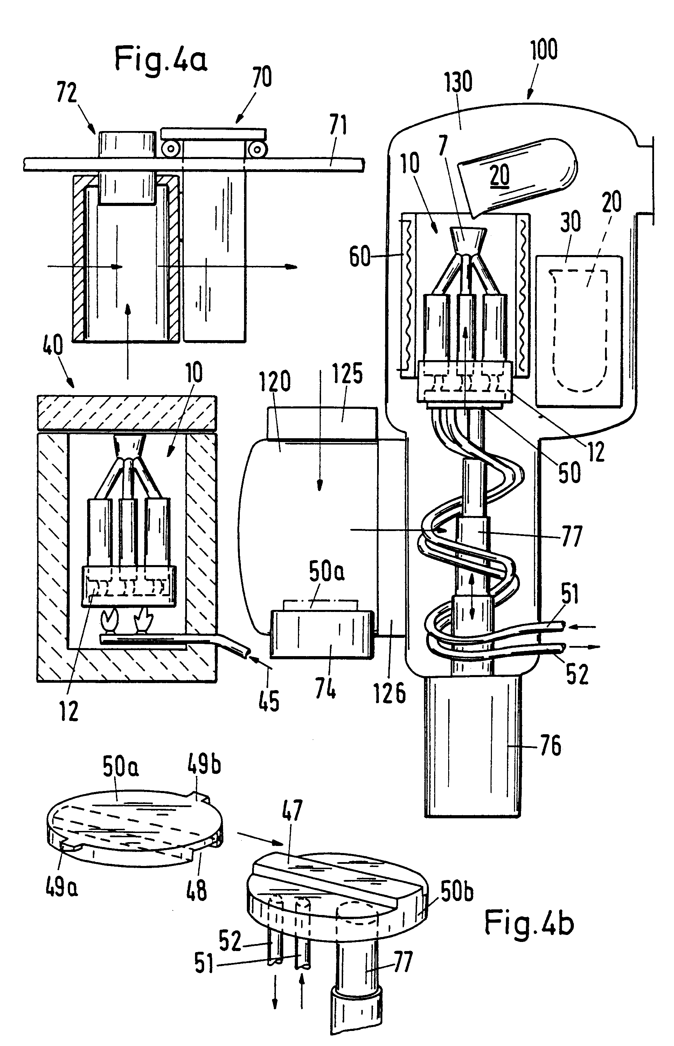

Die wesentlichen Merkmale des erfindungsgemässen Verfahrens werden nun anhand der schematischen Darstellung der Fig.4a näher erläutert. Die Herstellung der Gussform 10 wird nach bekannten Verfahrensschritten durchgeführt und muss hier nicht beschrieben werden. Unmittelbar vor dem Giessen wird die Gussform 10 erfindungsgemäss in einem separaten Aufheizofen 40 auf eine Temperatur über der Liquidustemperatur der Schmelze, beispielsweise auf 1500°C, erhitzt. In der Vakuumgiessanlage 100 wird die Legierung mit einem Induktionsofen 30 und in einem Tiegel 20 aufgeschmolzen und rund 100 bis 300 K - je nach Legierung und Form des Bauteils - über die Liquidustemperatur erhitzt.

Mittels eines Bewegungsautomaten 70 auf einer Schiene 71 und einer Greifvorrichtung 72 wird die erhitzte Gussform 10 aus dem Ofen 40 in die Schleuse 120 der Giessanlage 100 transportiert.In der Schleuse 120 mit den Schleusentoren 125 und 126 befindet sich eine Einrichtung 74, mit der ein Zusammenschluss der Gussform 10 mit dem Kühlorgan 50 herstellbar ist. Eine Möglichkeit, wie diese Einrichtung 74 beispielsweise funktionieren könnte, wird im folgenden erläutert.

Das Kühlorgan 50 besteht aus einer entfernbaren Kühlplatte 50a und einem Wärmetauscherelement 50b, das wassergekühlt und mit teilweise flexibeln Anschlussleitungen 51 und 52 versehen ist (siehe Figuren 4a und 4b). Die Kühlplatte 50a lässt sich gegenüber dem Wärmetauscherelement 50b verschieben, wobei eine Nut 48 und ein Kamm 47 eine geführte Bewegung ermöglicht. Beim Einschleusen der Gussform 10 befindet sich die Kühlplatte 50a (strichpunktiert markiert in Fig.4a) auf der Einrichtung 74. Beim Zusammenschluss von Kühlplatte 50a und Gussform 10 treten klauenartige Vorsprünge 49a und 49b am Rand der kreisförmigen Kühlplatte 50a bajonettverschlussartig in Eingriff mit den Nuten, die sich im oben erwähnten Ring 15 der Gussform 10 befinden. Die Einrichtung 74 übt die für den Zusammenschluss nötige Drehbewegung der Kühlplatte 50a aus.

Nachdem die Greifvorrichtung 72 des Bewegungsautomaten 70 aus der Schleuse 120 entfernt, diese evakuiert und das Schleusentor 126 geöffnet worden ist, schiebt die Einrichtung 74 die Kühlplatte 50a mit der Gussform 10 auf das Wärmetauscherelement 50b, das sich benachbart im untern Teil der Giesskammer 130 befindet. Durch die Hebe/absenkvorrichtung 76 mit dem Teleskoparm 77, auf dem das Kühlorgan 50 angeordnet ist, wird sodann die Gussform 10 in die Heizeinrichtung 60 (= Suszeptor), die sich in Betrieb befindet, eingefahren. Die Wiedererhitzung der Gussform 10, die während des Transports vom Ofen 40 in die Giessanlage 100 einen Wärmeverlust erlitten hat, soll durch die Heizeinrichtung auf eine Temperatur erfolgen, die mindestens 50 K höher als die Liquidustemperatur der Schmelze ist.

Mittels einer nicht dargestellten Vorrichtung wird die überhitzte Schmelze aus dem Schmelztiegel 20 in den Giesstrichter 7 gegossen. Die Schmelze füllt die Formschale und tritt in den Startern mit dem Kühlorgan 50 in Kontakt, wobei sich durch die schockartige Abkühlung spontan Kristallkeime an der Grenzfläche und darauf eine polykristalline Phase in den Basiszonen 3a bilden. Die polykristalline geht in eine gerichtet kristalline Phase über, die sich in den Mündungsbereich des Selektors 3b erstreckt. Dank der Verengung des Querschnitts im Selektor 3b und wegen dessen helixartigen Form ist es nur für einen einzigen der in der Basiszone 3a gebildeten Kristalle möglich, den Selektor zu durchwachsen und auf diese Weise als Keim der Einkristallphase zu wirken.

Nach Ablauf einer Startphase, während welcher die Schmelze im Sockelbereich erstarrt ist und die Gussform im oberen Bereich wiedererhitzt worden ist und zwar auf eine Temperatur, die über der Liquidustemperatur liegt, wird die Gussform 10 mittels der Absenkvorrichtung 76, 77 aus der Heizeinrichtung 60 kontrolliert herausgezogen. Da die Gussform 10 nur im Sockelbereich mit einer Wärmedämmung 12 ummantelt ist, kann nach Austritt aus der Heizeinrichtung 60 die Gussform 10 ungehindert Wärme an die Umgebung abstrahlen. Dadurch stellt sich vorteilhafterweise ein grösserer Temperaturgradient G an der Erstarrungsfront ein, als wenn die Wärme nur über das Kühlorgan 50 abgeführt würde.

Damit die Wärmeverluste während des Transports der vorgeheizten Gussform 10 in die Vakuumgiessanlage 100 tolerierbar bleiben, muss die Handhabung der Gussform durch den Bewegungsautomaten 70, das Einschleusen, das Zusammenschliessen mit dem Kühlorgan 50 sowie das Einfahren in die Heizeinrichtung ohne vermeidbare Verzögerungen durchgeführt werden. Die Gussform 10 muss nur bis zum oberen Rand der Wärmedämmung 12 in die Heizeinrichtung 60 eingeführt werden.

Da das Aufheizen der Gussform 10 separat und nicht in der Vakuumgiessanlage wie beim heute üblichen Suszeptorverfahren erfolgt, sind die Taktzeiten kürzer; d.h. man muss pro Guss die teure Giesskammer weniger lang belegen.

Das separate Aufheizen der Gussform 10 wird mit Vorteil in zwei Stufen durchgeführt: In einem ersten Ofen wird auf eine Temperatur zwischen rund 1000 und 1200 Grad Celsius vorerhitzt und in einem zweiten Ofen 40 wird die weitere Aufheizung auf beispielsweise 1500 Grad vorgenommen. Die Verweilzeiten dauern in beiden öfen je rund eine Stunde. Für den Ofen 40 kann ein Keramikbrandofen verwendet werden, der den Zwecken des Verfahrens angepasst worden ist. Geheizt kann beispielsweise mit gasförmigen Kohlenwasserstoffen 45, insbesondere Propan, werden. Selbstverständlich kann auch mittels Elektroöfen - insbesondere bei der ersten Stufe - geheizt werden. Elektrisches Heizen mittels des zweiten Ofens wird mit Vorteil unter Verwendung von Graphitstäben als Heizleiter - allerdings in einer Schutzgasatmosphäre oder im Vakuum - durchgeführt.

Das beschriebene Ausführungsbeispiel bezieht sich auf die Herstellung von Gussstücken durch einkristalline Erstarrung. Die Herstellung von gerichtet erstarrten Gussstücken kann nach dem gleichen Verfahren durchgeführt werden; der Unterschied liegt einzig darin, dass in der Gussform die Selektoren 3b fehlen.

## Patentansprüche

1. Giessverfahren zur Herstellung von gerichtet erstarrten oder einkristallinen Bauteilen in einer Vakuumgiessanlage mit einer Heizeinrichtung und einem Kühlorgan, das auf einer Absenkvorrichtung angeordnet ist,
dadurch gekennzeichnet, dass die Gussform, die im Sockelbereich mit einer Wärmedämmung versehen ist, vor dem Einschleusen in die Vakuumgiessanlage auf eine Temperatur erhitzt wird, die höher als die Liquidustemperatur der Schmelze ist, dass das Einschleusen und Einfahren der Gussform in die Heizeinrichtung ohne vermeidbare Verzögerungen durchgeführt wird und dass nach dem Vergiessen von überhitzter Schmelze die Gussform mittels der Absenkvorrichtung aus der Heizeinrichtung kontrolliert herausgezogen wird, wobei das Absenken nach Ablauf einer Startphase begonnen wird, während welcher die Schmelze im Sockelbereich erstarrt ist und die Gussform im oberen Bereich auf eine über der Liquidustemperatur liegenden Temperatur wiedererhitzt worden ist.

2. Verfahren nach Anspruch 1, dadurch gekennzeichnet, dass die Gussform nur bis zur Wärmedämmung des Sockelbereichs in die Heizeinrichtung eingeführt wird

3. Verfahren nach einem der Ansprüche 1 oder 2, dadurch gekennzeichnet, dass die Gussform ausserhalb der Giesskammer sowie danach in der Heizeinrichtung auf Temperaturen aufgeheizt wird, die mindestens 50 K höher als die Liquidustemperatur der Schmelze sind.

4. Verfahren nach einem der Ansprüche 1 bis 3, dadurch gekennzeichnet, dass die Gussform vor dem Einschleusen in die Giesskammer in einem ersten Ofen auf eine Temperatur zwischen rund 1000 und 1200 Grad Celsius vorerhitzt wird und dass in einem zweiten Ofen das weitere Aufheizen auf die Temperatur über der Liquidustemperatur vorgenommen wird.

5. Verfahren nach Anspruch 4, dadurch gekennzeichnet, dass im zweiten Ofen mit Kohlenwasserstoff, insbesondere Propan, geheizt wird.

6. Verfahren nach Anspruch 4, dadurch gekennzeichnet, dass im zweiten Ofen elektrisch in einer Schutzgasatmosphäre oder im Vakuum unter Verwendung von Graphitstäben als Heizleiter geheizt wird.

7. Verfahren nach einem der Ansprüche 1 bis 6, dadurch gekennzeichnet, dass die Schmelze in einem Schmelztiegel auf eine Temperatur erhitzt wird, die über jener der Gussform in der Heizeinrichtung liegt.

8. Verfahren nach einem der Ansprüche 1 bis 7, dadurch gekennzeichnet, dass die Heizeinrichtung vor dem Einfahren der Gussform in Betrieb genommen wird.

## Claims

1. A casting process for the production of directionally solidified or monocrystalline components in a vacuum casting plant with heating means and a cooling element, the latter being disposed on a lowering device, characterised in that the casting mould, which has heat insulation in its base zone, is heated, before introduction into the lock of the vacuum casting plant, to a temperature higher than the liquidus temperature of the melt, the casting mould is introduced into the lock and into the heating means without avoidable delays and after the casting of superheated melt the casting mould is removed by the lowering device from the heating means in a controlled manner, lowering starting after the termination of a starting phase in which the melt solidifies in the base zone and the casting mould has been reheated in its top zone to a temperature above the liquidus temperature.

2. A process according to claim 1, characterised in that the casting mould is introduced into the heating means only as far as the heat insulation of the base zone.

3. A process according to claim 1 or 2, characterised in that the casting mould is heated outside the casting chamber, then subsequently in the heating means, to temperatures at least 50 K above the liquidus temperature of the melt.

4. A process according to any of claims 1 to 3, characterised in that before being introduced through the lock into the casting chamber the casting mould is preheated in a first oven to a temperature between approximately 1000 and 1200°C, then further heated in a second oven to the temperature above the liquidus temperature.

5. A process according to claim 4, characterised in that heating using a hydrocarbon, more particularly propane, is carried out in the second oven.

6. A process according to claim 4, characterised in that heating is carried out in the second oven electrically in a protective gas atmosphere or in vacuo with the use of graphite rods as heating conductors.

7. A process according to any of claims 1 to 6, characterised in that the melt is heated in a crucible to a temperature above the temperature of the casting mould in the heating means.

8. A process according to any of claims 1 to 7, characterised in that the heating means is started before the introduction of the casting mould.

## Revendications

1. Procédé par coulage de fabrication de pièces de construction monocristallines ou obtenues par solidification directionnelle dans une installation de coulée sous vide avec un dispositif de chauffage et un organe de refroidissement, qui est placé sur un dispositif d'abaissement, caractérisé en ce que le moule de coulée, qui est doté dans la zone du socle d'une isolation thermique, est chauffé avant d'être enfermé dans l'installation de coulée sous vide, à une température qui est supérieure à la température liquidus de la masse en fusion, en ce que le moule de coulée est enfermé et introduit dans le dispositif de chauffage sans retards évitables et en ce qu'après la coulée de la masse en fusion surchauffée, le moule est extrait du dispositif de chauffage, de manière contrôlée, au moyen du dispositif d'abaissement, l'abaissement commençant à l'expiration d'une phase de démarrage, au cours de laquelle la masse en fusion est solidifiée dans la zone du socle et le moule a à nouveau été chauffé dans la zone haute, à une température supérieure à la température liquidus.

2. Procédé selon la revendication 1, caractérisé en ce que le moule n'est introduit que jusqu'à l'isolation thermique de la zone du socle, dans le dispositif de chauffage.

3. Procédé selon l'une des revendications 1 ou 2, caractérisé en ce que le moule est chauffé à l'extérieur de la chambre de coulée ainsi qu'après dans le dispositif de chauffage à des températures qui sont au moins supérieures de 50 K à la température liquidus de la masse en fusion.

4. Procédé selon l'une des revendications 1 à 3, caractérisé en ce que le moule est préchauffé avant d'être enfermé dans la chambre de coulée dans un premier four, à une température comprise entre 1 000 et 1 200 degrés Celsius et en ce que dans un second four, il est procédé à la poursuite du chauffage à la température supérieure à la température liquidus.

5. Procédé selon la revendication 4, caractérisé en ce que dans le second four on chauffe avec un hydrocarbure, en particulier du propane.

6. Procédé selon la revendication 4, caractérisé en ce que dans le second four on chauffe électriquement dans une atmosphère de gaz de protection ou sous vide, par utilisation de barres de graphite en tant que conducteurs de chaleur.

7. Procédé selon l'une des revendications 1 à 6, caractérisé en ce que la masse en fusion est chauffée dans un creuset à une température qui est supérieure à celle du moule dans le dispositif de chauffage.

8. Procédé selon l'une des revendications 1 à 7, caractérisé en ce que le dispositif de chauffage est mis en service avant introduction du moule.
